# FASCICULE DE BREVET EUROPEEN

(11) **EP 1 168 366 B1**
(45) Date de publication et mention de la délivrance du brevet: **29.03.2006**
(21) Numéro de dépôt: 01401557.2
(22) Date de dépôt: 14.06.2001
(51) Int. Cl.: G11C 17/14, G11C 17/18, G06F 11/20

(54) **Circuit monostable programmable à haute fiabilité**
Programmierbare monostabile Schaltung mit hoher Zuverlässigkeit
Programmable monostable circuit with high reliability

(30) Priorité: 27.06.2000 FR 0008215
(43) Date de publication de la demande: 02.01.2002
(73) Titulaire: STMicroelectronics S.A., 92120 Montrouge (FR)
(72) Inventeur: Ferrant, Richard, F-38190 Crolles (FR)
(74) Mandataire: Casalonga, Axel

(56) Documents cités:
- EP-A- 0 419 760
- US-A- 5 384 746
- US-A- 5 570 313
- PATENT ABSTRACTS OF JAPAN vol. 1999, no. 09, 30 juillet 1999 (1999-07-30) & JP 11 120791 A (NKK CORP), 30 avril 1999 (1999-04-30)

## Description

La présente invention concerne le domaine des circuits monostables, en particulier des circuits monostables utilisés pour la gestion des redondances dans les mémoires.

Les mémoires sont généralement constituées d'une matrice de lignes et de colonnes de cellules mémoire. Pour une mémoire de taille donnée, on prévoit un certain nombre de lignes et un certain nombre de colonnes supplémentaires destinées à remplacer des lignes ou des colonnes dont les tests de fonctionnement après fabrication s'avéreraient négatifs.

Cette opération de remplacement d'une ou plusieurs lignes et d'une ou plusieurs colonnes nécessite de reconfigurer la mémoire ou plus généralement le circuit qui doit être réparé. Toutefois, cette reconfiguration ne doit pas dégrader les performances du circuit tant en terme de consommation qu'en terme de vitesse. A cet effet, on utilise des fusibles aptes à être mis en circuit ouvert par le tir d'un faisceau laser. A proximité du fusible, doit être disposé un circuit permettant de reconnaître son état, ouvert ou fermé et de fournir une information numérique relative à cet état. Il va de soi que ce circuit doit être également de petite taille et à faible consommation.

Le test d'une mémoire consiste généralement à adresser toutes les cellules en écriture selon un modèle prédéterminé, puis en lecture pour établir une cartographie on détecte ainsi d'éventuelles anomalies. On organise alors le claquage (la mise en circuit ouvert) des fusibles pour modifier l'interprétation de l'adressage des colonnes défectueuses.

Les moyens de claquage des fusibles dépendent de la nature des fusibles utilisés. Dans le cas de fusibles claquables par laser, tous les fusibles associés au remplacement de colonnes défectueuses de tous les circuits réalisés sur une même plaque de circuit intégré sont claqués successivement au moyen d'un laser. L'abrégé du document JP 11120791 semble concerner un circuit redondant à faible consommation dans lequel un fusible disposé entre deux transistors en série. La commande de l'un des transistors est mise à la masse et l'autre sur une entrée du circuit. L'entrée du circuit est également reliée à une entrée d'une porte NAND dont l'autre entrée est reliée au point commun entre le fusible et l'autre transistor.

La présente invention propose un circuit réalisant une interface fiable entre le fusible et une sortie numérique.

La présente invention propose un circuit peu sensible aux perturbations, notamment dues aux rayons alpha ou aux ions lourds.

Un circuit claquable à sortie numérique, selon un aspect de l'invention, comprend un ensemble auto-stable de bascules, un ensemble de commande de l'ensemble auto-stable, un ensemble claquable, une porte logique comprenant une première entrée reliée à un point commun entre l'ensemble auto-stable et l'ensemble claquable, et une deuxième entrée reliée à une entrée de commande du circuit, et un interrupteur commandé par une sortie de la porte logique et disposé entre l'ensemble auto-stable et la masse du circuit. L'ensemble auto-stable permet une conservation de l'information malgré des conditions d'environnement sévères, par exemple dues à des rayons alpha ou des ions lourds incidents.

Dans un mode de réalisation de l'invention, l'ensemble claquable comprend un élément claquable et un interrupteur disposés en série entre l'ensemble auto-stable et une masse.

Dans un mode de réalisation de l'invention, l'élément claquable est relié à l'ensemble auto-stabte.

Dans un autre mode de réalisation de l'invention, l'interrupteur de l'ensemble claquable est relié à l'ensemble auto-stable.

Avantageusement, la porte logique est de type NAND.

Dans un mode de réalisation de l'invention, l'ensemble de commande comprend deux interrupteurs de commande. L'entrée de commande du circuit peut être reliée à la borne de commande desdits deux interrupteurs de commande. Deux inverseurs peuvent être disposés entre l'entrée du circuit et la borne de commande de l'un desdits interrupteurs de commande.

Dans un mode de réalisation de l'invention, l'ensemble auto-stable comprend au moins quatre interrupteurs, de préférence huit.

La présente invention concerne également un procédé de lecture d'un élément claquable associé à un ensemble auto-stable de bascules, dans lequel :
- avant claquage, une entrée de commande reliée à une première entrée d'une porte logique étant à une première valeur logique, des interrupteurs de commande sont bloqués imposant dans une deuxième entrée de ladite porte logique une valeur logique telle que une sortie soit à une valeur logique complémentaire,
- avant claquage, ladite entrée de commande étant à la valeur logique complémentaire à la première valeur logique ne modifie pas la sortie, la valeur logique de la deuxième entrée de la porte logique étant maintenue,
- après claquage, l'entrée de commande reliée à la première entrée de ladite porte logique étant à une première valeur logique, les interrupteurs de commande sont bloqués, imposant à la deuxième entrée de ladite porte logique une valeur logique telle que la sortie se maintienne dans ladite valeur logique complémentaire et qu'après que ladite entrée de commande a reçu une valeur logique complémentaire, la sortie passe définitivement à ladite première valeur logique.

Grâce à l'invention, on dispose d'un circuit compact c'est-à-dire occupant une faible surface de silicium, robuste, et à faible consommation quel que soit l'état, ouvert ou fermé; de l'élément claquable.

La présente invention sera mieux comprise à la lecture de la description détaillée d'un mode de réalisation pris à titre d'exemple nullement limitatif et illustré par les dessins annexés :
- la figure 1 est un schéma d'un mode de réalisation du circuit selon l'invention ;
- la figure 2 est une variante de la figure 1 ;
- la figure 3 est un diagramme de fonctionnement, l'élément claquable étant à l'état fermé ; et
- la figure 4 est un diagramme de fonctionnement, l'élément claquable étant à l'état ouvert.

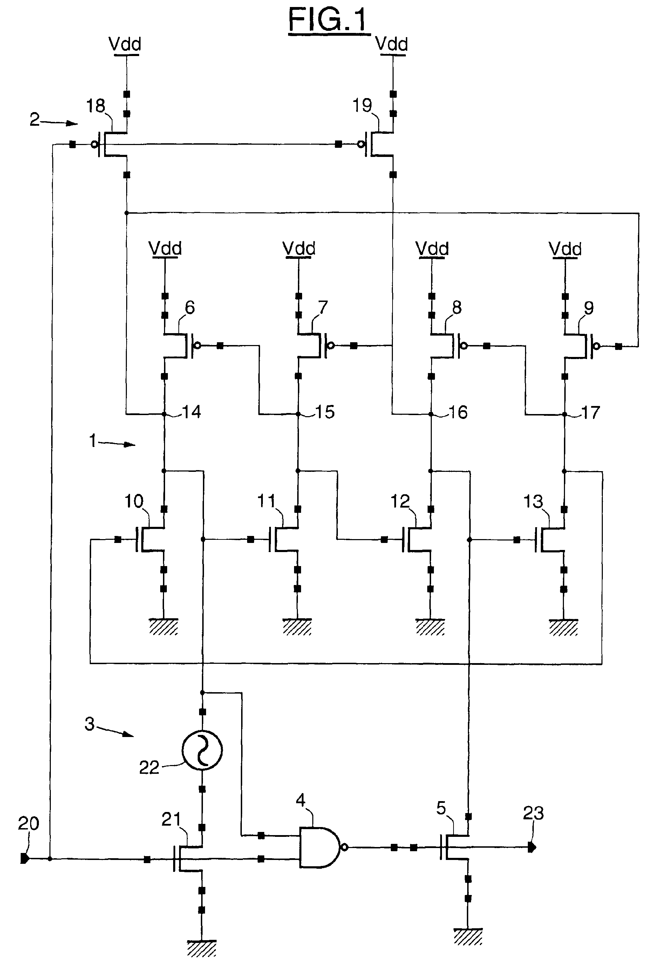

Comme on peut le voir sur la figure 1, le circuit intégré comprend un ensemble auto-stable 1, un ensemble de commande 2 de l'ensemble auto-stable 1, un ensemble claquable 3 relié à l'ensemble auto-stable 1, une porte logique 4 et un interrupteur 5 relié à la sortie de la porte logique 4 et à l'ensemble auto-stable 1.

L'ensemble auto-stable 1 est pourvu de huit interrupteurs référencés 6 à 13, ici de technologie MOS, quatre transistors PMOS 6 à 9 et quatre transistors NMOS 10 à 13. Les sources des transistors PMOS 6 à 9 sont reliées à la tension d'alimentation Vdd, par exemple égale à 1,8 volt, et les sources des transistors MMOS 10 à 13 sont reliées à la masse du circuit. Les drains des transistors PMOS 6 à 9 sont reliés respectivement aux drains des transistors NMOS 10 à 13.

Les grilles des transistors PMOS 6, 7, 8 et 9 sont reliées respectivement aux drains des transistors PMOS 7, 8, 9 et 6. De même, les drains des transistors NMOS 10, 11, 12 et 13 sont reliés respectivement aux grilles des transistors NMOS 11, 12, 13 et 10.

L'ensemble auto-stable 1 se comporte comme une cellule mémoire dans laquelle l'information est stockée dans quatre noeuds portant les références 14, 15, 16 et 17 qui sont respectivement les drains des transistors PMOS 6, 7, 8 et 9 et les drains des transistors NMOS 10, 11, 12 et 13. Le noeud 14 contient l'information sous forme de niveau logique X. Il vient donc X = 1 ou X = 0. Le noeud suivant 15 contient l'information sous forme de niveau logique C(X) représentant le niveau logique complémentaire du niveau logique X. On a donc : C(X) = 0 pour X = 1 et C(X) = 1 pour X=0.

Les noeuds 16 et 17 contiennent l'information sous forme d'un niveau logique respectif Y et C(Y) avec Y = X et C(Y) = C(X). L'ensemble auto-stable 1 permet de stocker un même niveau logique en deux noeuds différents respectivement 14 et 16, 15 et 17.

Pour des raisons de simplicité, on pourrait concevoir un ensemble auto-stable comportant seulement quatre transistors. Toutefois la fiabilité de fonctionnement d'un tel ensemble serait dégradée car un tel ensemble formant mémoire est très sensible à la perte d'informations due à l'apport d'énergie venant de l'extérieur tel que, par exemple, l'apport d'énergie d'un ion lourd traversant le matériau semi-conducteur au niveau de la jonction où l'un des deux niveaux logiques est stocké. La jonction se comporte comme une capacité que les paires électrons/trous créés lors de l'impact de l'ion lourd viennent charger. La variation de tension aux bornes de la capacité est déterminée par le rapport de la variation de charge sur la valeur de la capacité. Cette variation de tension peut alors atteindre un niveau tel que le niveau logique qui est stocké dans la jonction bascule, entraînant le basculement du niveau logique complémentaire. Les niveaux logiques complémentaires se confirmant l'un l'autre, il s'ensuit que la cellule mémoire se trouve dans un état stable différent de l'état initial.

Les capacités des jonctions atteignent à ce jour des valeurs très faibles. Il en résulte que la variation de tension peut atteindre facilement le seuil de basculement de l'information mémorisée pour de faibles variations de charge. On préférera donc utiliser un ensemble auto-stable 1 qui présente une redondance d'informations assurant une haute sécurité de fonctionnement.

L'ensemble de commande 2 comprend deux interrupteurs, ici sous la forme de deux transistors PMOS 18 et 19. Les grilles des transistors de commande 18 et 19 sont reliées à une entrée de commande du circuit notée 20. Les sources des transistors de commande 18 et 19 sont reliées à la tension d'alimentation Vdd. Le drain du transistor de commande 18 est relié au noeud 14 tandis que le drain du transistor de commande 19 est relié au noeud 16 de l'ensemble auto-stable 1.

L'ensemble claquable 3 comprend un interrupteur 21, ici un transistor NMOS et un fusible 22 apte à être claqué c'est-à-dire mis en circuit ouvert, par exemple au moyen d'un faisceau laser qui provoque sa fusion. Le fusible 22 peut se présenter dans un circuit intégré sous la forme d'une bande conductrice de faible largeur et apte à être atteinte par un faisceau laser en sortie de fabrication du circuit semi-conducteur. Le fusible 22 est relié d'un côté au noeud 14 de l'ensemble auto-stable 1 et de l'autre côté au drain du transistor 21. La source du transistor 21 est reliée à la masse du circuit et sa grille est reliée à l'entrée de commande 20.

La porte logique 4 sera, avantageusement, de type NAND avec une première entrée reliée au noeud 14, on rappelle ici qu'il est également relié au fusible 22, et une deuxième entrée reliée à l'entrée de commande 20. La sortie de la porte logique 4 est reliée à la sortie du circuit notée 23 et à l'entrée de commande de l'interrupteur 5, dans le cas présent à sa grille, l'interrupteur 5 étant un transistor NMOS, dont le drain est relié au noeud 16 et dont la source est reliée à la masse du circuit.

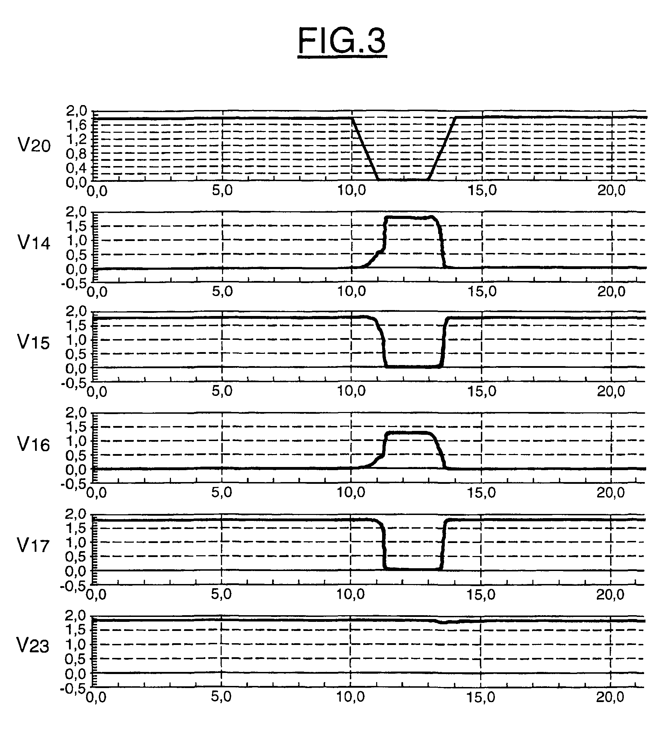

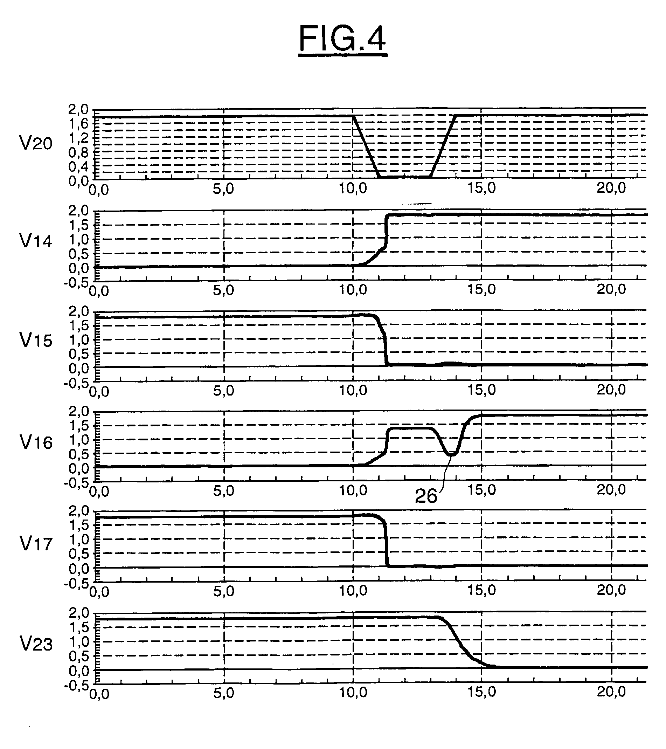

Sur les figures 3 et 4, les courbes de tensions notées Vx indiquent la tension au noeud ou point référencée x. Le fonctionnement du circuit est le suivant. Avant claquage, le fusible 22 peut être assimilé à un circuit fermé. Le drain du transistor 21, la première entrée de la porte logique 4 et le noeud 14 sont au même potentiel.

Lorsque l'entrée 20 se situe à un niveau logique 1, le transistor 21 est passant donc le noeud 14 est à un niveau 0. Les transistors de commande 18 et 19 sont bloqués. La porte logique 4 voit un niveau logique 0 sur sa première entrée et 1 sur sa deuxième entrée. Sa sortie est au niveau 1. Le transistor 5 est donc passant, le noeud 16 est donc mis à un niveau 0 et les noeuds 15 et 17 prennent les valeurs complémentaires c'est-à-dire sont au niveau 1.

Le fusible 22 étant toujours à l'état fermé, lorsque l'entrée de commande 20 commute au niveau 0, le transistor 21 se bloque tandis que les transistors de commande 18 et 19 deviennent passants. Les noeuds 14 et 16 passent au niveau logique 1 tandis que les noeuds 15 et 17 prennent les valeurs complémentaires, niveau logique 0. La porte logique 4 voit un niveau logique 1 sur sa première entrée et 0 sur sa deuxième entrée. Sa sortie est donc au niveau logique 1 et le transistor 5 reste passant. Il se produit alors un conflit entre le transistor de commande 19 et le transistor 5. En d'autres termes, le niveau du noeud 16 tend à augmenter en raison de l'état passant du transistor de commande 19 et à diminuer en raison de l'état passant du transistor 5. Toutefois, le transistor de commande 19 est plus fortement dimensionné que le transistor 5 qui est de relativement petite taille. Il en résulte que le noeud 16 prend le niveau logique 1. Les noeuds 15 et 17 prennent le niveau logique 0 complémentaire du niveau logique 1 des noeuds 14 et 16. On comprend donc que quelle que soit la valeur logique de l'entrée 20, la sortie 23 présente une valeur logique constante dans le cas présent 1. Ce fonctionnement est illustré sur la figure 3.

Après claquage, le fusible 22 se comporte comme un circuit ouvert. En d'autres termes, la première entrée de la porte logique 4 est reliée seulement au noeud 14 et plus au drain du transistor 21. Immédiatement après le claquage du fusible 22 et tant que l'entrée de commande 20 reste au niveau logique 1, l'état antérieur se maintient, à savoir que les noeuds 14 et 16 restent au niveau 0 et la sortie 23 au niveau 1. En effet, le noeud 14 conserve son niveau logique 0 non plus à cause du fusible 22 et de l'interrupteur 21 à l'état passant mais simplement en conservant la valeur logique opposée à la valeur logique du noeud 17 qui lui-même présente une valeur logique opposée à celle du noeud 16 lequel est mis à la valeur logique 0 par le transistor 5 maintenu à l'état passant par la sortie de la porte logique 4.

Lorsque l'entrée 20 commute au niveau logique 0, les transistors de commande 18 et 19 deviennent passants ce qui entraîne les noeuds 14 et 16 au niveau logique 1 et ce, pour le noeud 16, malgré l'état passant du transistor 5 dont on a vu plus haut que son faible dimensionnement créait une priorité au niveau logique imposé par le transistor de commande 19 en cas de conflit entre ces deux transistors. Les noeuds 15 et 17 prennent les valeurs logiques opposées. La porte logique 4 voit donc la valeur logique 1 du noeud 14 sur sa première entrée et la valeur logique 0 de l'entrée 20 sur sa deuxième entrée et conserve donc une sortie à la valeur logique 1.

Lors de la commutation suivante de l'entrée de commande 20, c'est-à-dire son retour au niveau logique 1, les transistors de commande 18 et 19 se bloquent à nouveau. Le transistor 5 toujours passant tend à entraîner le noeud 16 vers une valeur plus faible, vers la valeur logique 0 comme on peut le constater sur la figure 4. Toutefois, avant le passage du noeud 16 à la valeur logique 0, la porte logique 4 voit sur sa première entrée la valeur logique 1 conservée par le noeud 14 et sur sa deuxième entrée la valeur logique 1 provenant de l'entrée de commande 20. La porte logique 4 envoie sur sa sortie une valeur logique 0 ce qui provoque le blocage du transistor 5. Le noeud 16 qui avait eu tendance à descendre vers le niveau logique 0 remonte alors au niveau logique 1 sous l'influence des transistors 6 à 13 de l'ensemble auto-stable 1 qui n'ont pas basculé. La sortie 23 du circuit passe donc à la valeur 0 et y reste quelle que soit l'évolution ultérieure de la valeur logique de l'entrée de commande 20. Le fait que l'on observe une variation 26 vers le bas de la tension au noeud 16 sur la figure 4 lors du passage de l'entrée de commande du niveau 0 au niveau 1 est due à la lenteur de fonctionnement de la porte logique 4.

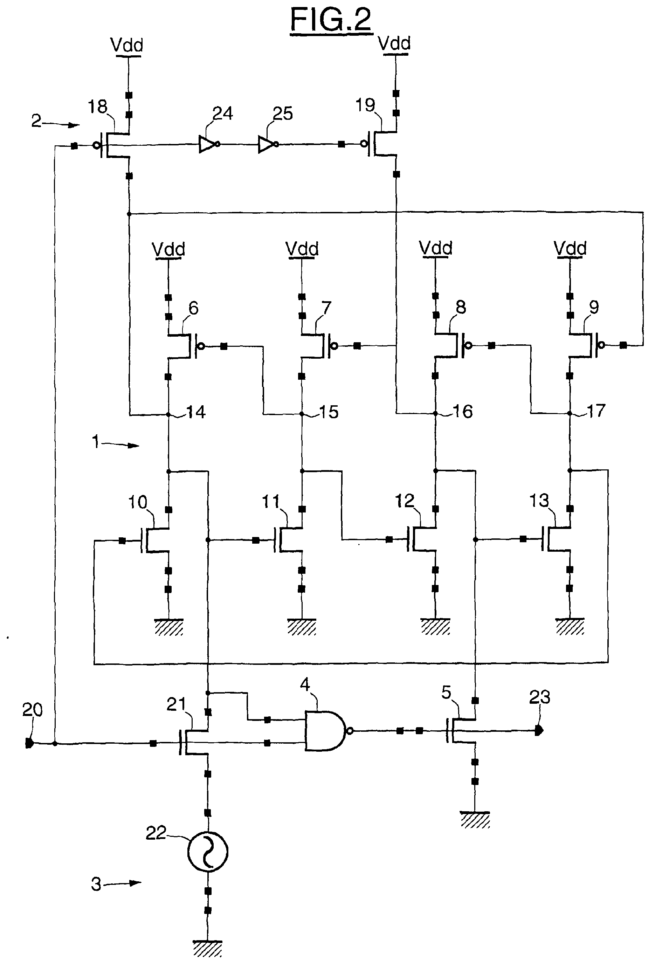

Sur la figure 2, est illustrée une variante semblable à la précédente à ceci près que dans l'ensemble claquable 3, l'interrupteur 21 et le fusible 22 sont inversés, le fusible 22 étant disposé entre la masse et la source du transistor 21. Le drain du transistor 21 est relié au noeud 14 et sa grille est toujours reliée à l'entrée de commande 20. Le fonctionnement du circuit tel que décrit ci-dessus n'est pas modifié.

De plus, deux inverseurs 24 et 25 sont disposés entre l'entrée de commande 20 et la grille du transistor de commande 19. Ces deux inverseurs 24 et 25 permettent de ralentir la commutation du transistor 19 et donc de diminuer les conflits entre le transistor de commande 19 et le transistor 5 ce qui permet de réduire la consommation du circuit lors des commutations. En particulier lors du premier retour au niveau logique 1 de l'entrée de commande 20 après le claquage du fusible 22, ces inverseurs 24 et 25 permettent au transistor 19 de se bloquer légèrement plus tardivement donc de maintenir une tension plus élevée au noeud 16, ce qui accroît la stabilité de fonctionnement de l'ensemble auto-stable 1 en permettant à la porte logique 4 de commuter plus tôt relativement au blocage du transistor de commande 19 et par conséquent au transistor 5 de se bloquer plus tôt également relativement au blocage du transistor de commande 19, d'où une réduction de la diminution de la tension au noeud 16 que l'on constate sur la courbe correspondante de la figure 4.

Enfin, l'invention permet de réaliser un circuit qui sert d'interface entre un fusible et un autre circuit auquel est destinée l'information logique présente sur la sortie 23 relative à l'état du fusible 22 de façon relativement simple avec un faible nombre de transistors. Le fusible occupe généralement une surface importante sur un circuit en raison des risques de détérioration des éléments voisins lors du tir laser destiné à le claquer. Or le circuit décrit ci-dessus, en référence à la figure 2, peut être réalisé sur un seul côté d'une surface rectangulaire sur laquelle est formé le fusible. On peut donc disposer plusieurs fusibles côte à côte en réduisant la surface de sécurité par fusible, entre fusibles et circuit intégré proprement dit dans la mesure où un fusible voisin ne risque pas d'être endommagé par le claquage d'un autre fusible. On peut ainsi optimiser l'utilisation de la surface de silicium. L'utilisation dans le circuit d'un élément auto-stable à redondance permet une grande sécurité de fonctionnement dans la mesure où l'arrivée d'un ion lourd ou d'un rayon alpha sur la jonction de l'un des transistors 6 à 13 de l'ensemble auto-stable ne mettra pas en cause son fonctionnement et ne provoquera pas de modification de la valeur logique de sortie. Le circuit décrit ci-dessus est d'autant plus intéressant que la largeur de gravure est petite ce qui provoque une réduction des éléments autres que le fusible et donc une augmentation relative de la surface occupée par le fusible dans la surface totale du circuit claquable.

L'invention s'applique notamment aux codes d'identification de microprocesseurs, aux redondances de mémoires volatiles, aux amplificateurs, au marquage définitif sécurisé, dans le domaine des cartes bancaires ou de paiement avec code d'empêchement de lecture.

## Revendications

1. Circuit claquage à sortie numérique comprenant un ensemble claquable (3) et une porte logique (4), **caractérisé par le fait que** le circuit comprend un ensemble autostable de bascule (1), un ensemble de commande (2) de l'ensemble auto-stable, la porte logique (4) comprenant une première entrée reliée à un point commun entre l'ensemble auto-stable et l'ensemble claquable, et une deuxième entrée reliée à une entrée de commande (20) du circuit, et un interrupteur (5) commandé par une sortie de la porte logique et disposé entre l'ensemble auto-stable et la masse du circuit.

2. Circuit selon la revendication 1, **caractérisé par le fait que** l'ensemble claquable comprend un élément claquable (22) et un interrupteur (21) disposés en série entre l'ensemble auto-stable et une masse.

3. Circuit selon la revendication 2, **caractérisé par le fait que** l'élément claquable est relié à l'ensemble auto-stable.

4. Circuit selon la revendication 2, **caractérisé par le fait que** l'interrupteur de l'ensemble claquable est relié à l'ensemble auto-stable.

5. Circuit selon l'une quelconque des revendications précédentes, **caractérisé par le fait que** là porte logique est de type NAND.

6. Circuit selon l'une quelconque des revendications précédentes, **caractérisé par le fait que** l'ensemble de commande comprend deux interrupteurs de commande (18, 19).

7. Circuit selon la revendication 6, **caractérisé par le fait qu'**une entrée de commande (20) du circuit est reliée à la borne de commande desdits deux interrupteurs de commande.

8. Circuit selon la revendication 6 ou 7, **caractérisé par le fait que** deux inverseurs (24, 25) sont disposés entre l'entrée du circuit et la borne de commande de l'un desdits interrupteurs de commande.

9. Circuit selon l'une quelconque des revendications précédentes, **caractérisé par le fait que** l'ensemble auto-stable comprend au moins quatre interrupteurs préférablement huit interrupteurs.

10. Procédé de lecture d'un élément claquable (22) associé à un ensemble auto-stable de bascules (1), dans lequel :
- avant claquage, une entrée de commande (20) reliée à une première entrée d'une porte logique (4) étant à une première valeur logique, des interrupteurs de commande (18, 19) sont bloqués imposant dans une deuxième entrée de ladite porte logique (4) une valeur logique telle qu'une sortie de la porte logique soit à une valeur logique complémentaire,
- avant claquage, ladite entrée de commande (20) étant à la valeur logique complémentaire à la première valeur logique ne modifie pas la sortie, la valeur logique de la deuxième entrée de la porte logique (4) étant maintenue,
- après claquage, l'entrée de commande (20) reliée à la première entrée de ladite porte logique (4) étant à une première valeur logique, les interrupteurs de commande sont bloqués, imposant à la deuxième entrée de ladite porte logique (4) une valeur logique telle que la sortie se maintienne dans ladite valeur logique complémentaire et qu'après que ladite entrée de commande (20) a reçu une valeur logique complémentaire, la sortie passe définitivement à ladite première valeur logique.

## Patentansprüche

1. Durchschlag-Schaltung mit digitalem Ausgang, die eine durchschlagbare Einheit (3) und ein Logikgatter (4) aufweist, **dadurch gekennzeichnet, dass** die Schaltung eine eigenstabile Kippschaltungseinheit (1) und eine Steuereinheit (2) für die eigenstabile Einheit enthält, wobei das Logikgatter (4) einen ersten Eingang, der mit einem gemeinsamen Punkt zwischen der eigenstabilen Einheit und der durchschlagbaren Einheit und einen zweiten Eingang aufweist, der mit einem Steuereingang (20) der Schaltung verbunden ist, und dass die Schaltung einen Unterbrecher (5) enthält, der von einem Ausgang des Logikgatters gesteuert wird und zwischen der eigenstabilen Einheit und der Masse der Schaltung liegt.

2. Schaltung nach Anspruch 1, **dadurch gekennzeichnet, dass** die durchschlagbare Einheit ein durchschlagbares Element (22) und einen Unterbrecher (21) aufweist, die in Reihe zwischen der eigenstabilen Einheit und Masse angeordnet sind.

3. Schaltung nach Anspruch 2, **dadurch gekennzeichnet, dass** das durchschlagbare Element mit der eigenstabilen Einheit verbunden ist.

4. Schaltung nach Anspruch 2, **dadurch gekennzeichnet, dass** der Unterbrecher der durchschlagbaren Einheit mit der eigenstabilen Einheit verbunden ist.

5. Schaltung nach einem der vorhergehenden Ansprüche, **dadurch gekennzeichnet, dass** das Logikgatter vom Typ NAND ist.

6. Schaltung nach einem der vorhergehenden Ansprüche, **dadurch gekennzeichnet, dass** die Steuereinheit zwei Steuer-Unterbrecher (18, 19) aufweist.

7. Schaltung nach Anspruch 6, **dadurch gekennzeichnet, dass** ein Steuereingang (20) der Schaltung mit dem Steueranschluss der beiden Steuer-Unterbrecher verbunden ist.

8. Schaltung nach Anspruch 6 oder 7, **dadurch gekennzeichnet, dass** zwei Umschalter (24, 25) zwischen dem Eingang der Schaltung und dem Steueranschluss eines der Steuer-Unterbrecher angeordnet sind.

9. Schaltung nach einem der vorhergehenden Ansprüche, **dadurch gekennzeichnet, dass** die eigenstabile Einheit mindestens vier Unterbrecher, vorzugsweise acht Unterbrecher aufweist.

10. Verfahren zum Lesen eines durchschlagbaren Elements (22), das einer eigenstabilen Einheit von Kippschaltungen (1) zugeordnet ist, bei dem:
- vor dem Durchschlagen, wenn ein mit einem ersten Eingang eines Logikgatters (4) verbundener Steuereingang (20) auf einem ersten logischen Wert ist, Steuer-Unterbrecher (18, 19) gesperrt sind und einem zweiten Eingang des Logikgatters (4) einen solchen logischen Wert aufzwingen, dass ein Ausgang des Logikgatters sich auf einem komplementären logischen Wert befindet,
- vor dem Durchschlagen, wenn der Steuereingang (20) auf dem zum ersten logischen Wert komplementären logischen Wert ist, er den Ausgang nicht verändert, wobei der logische Wert des zweiten Eingangs des Logikgatters (4) aufrechterhalten wird,
- nach dem Durchschlagen, wenn der mit dem ersten Eingang des Logikgatters (4) verbundene Steuereingang (20) auf einem ersten logischen Wert ist, die Steuer-Unterbrecher gesperrt sind und dem zweiten Eingang des Logikgatters (4) einen derartigen logischen Wert aufzwingen, dass der Ausgang auf dem komplementären logischen Wert bleibt, und dass, nachdem der Steuereingang (20) einen komplementären logischen Wert empfangen hat, der Ausgang definitiv auf den ersten logischen Wert übergeht.

## Claims

1. Blowable circuit with digital output comprising a blowable assembly (3) and a logic gate (4), **characterized in that** the circuit comprises an auto-stable assembly of latches (1), a control assembly (2) for the auto-stable assembly, the logic gate (4) comprising a first input linked to a common point between the auto-stable assembly and the blowable assembly, and a second input linked to a control input (20) of the circuit, and a breaker (5) controlled by an output of the logic gate and arranged between the auto-stable assembly and earth of the circuit.

2. Circuit according to Claim 1, **characterized in that** the blowable assembly comprises a blowable element (22) and a breaker (21) which are arranged in series between the auto-stable assembly and an earth.

3. Circuit according to Claim 2, **characterized in that** the blowable element is linked to the auto-stable assembly.

4. Circuit according to Claim 2, **characterized in that** the breaker of the blowable assembly is linked to the auto-stable assembly.

5. Circuit according to any one of the preceding claims, **characterized in that** the logic gate is of NAND type.

6. Circuit according to any one of the preceding claims, **characterized in that** the control assembly comprises two control breakers (18, 19).

7. Circuit according to Claim 6, **characterized in that** a control input (20) of the circuit is linked to the control terminal of the said two control breakers.

8. Circuit according to Claim 6 or 7,
**characterized in that** two inverters (24, 25) are arranged between the input of the circuit and the control terminal of one of the said control breakers.

9. Circuit according to any one of the preceding claims, **characterized in that** the auto-stable assembly comprises at least four breakers, preferably eight breakers.

10. Process for reading a blowable element (22) associated with an auto-stable assembly of latches (1), in which:
- before blowing, a control input (20) linked to a first input of a logic gate (4) being at a first logic value, control breakers (18, 19) are off, imposing in a second input of the said logic gate (4) a logic value such that an output of the logic gate is at a complementary logic value,
- before blowing, the said control input (20) being at the logic value complementary to the first logic value does not modify the output, the logic value of the second input of the logic gate (4) being maintained,
- after blowing, the control input (20) linked to the first input of the said logic gate (4) being at a first logic value, the control breakers are off, imposing on the second input of the said logic gate (4) a logic value such that the output is maintained in the said complementary logic value and that, after the said control input (20) has received a complementary logic value, the output goes permanently to the said first logic value
